# EUROPÄISCHE PATENTSCHRIFT

(11) **EP 2 984 689 B1**
(45) Veröffentlichungstag und Bekanntmachung des Hinweises auf die Patenterteilung: **05.07.2017**
(21) Anmeldenummer: 14726883.3
(22) Anmeldetag: 22.05.2014
(51) Int. Cl.: H01L 41/04, H01L 41/047

(54) **PIEZOELEKTRISCHE AKTOREINRICHTUNG UND DAMIT AUSGESTATTETES VENTIL**
PIEZOELECTRICAL ACTUATOR AND THUS EQUIPPED VALVE
DISPOSITIF ACTIONNEUR PIÉZO-ÉLECTRIQUE ET VALVE AINSI ÉQUIPÉ

(30) Priorität: 08.06.2013 DE 102013009646
(43) Veröffentlichungstag der Anmeldung: 17.02.2016
(73) Patentinhaber: Festo AG & Co. KG, 73734 Esslingen (DE)
(72) Erfinder: PALERMO, Gino, 73072 Donzdorf (DE); ANDERLE, Jens, 73054 Eislingen (DE); WIRTL, Hannes, 86956 Schongau (DE); HOITZ, Gerd, D-73114 Schlat (DE)
(74) Vertreter: Patentanwälte Magenbauer & Kollegen Partnerschaft mbB
(86) Internationale Anmeldenummer: PCT/EP2014/001376
(87) Internationale Veröffentlichungsnummer: WO 2014/194986

(56) Entgegenhaltungen:
- EP-B1- 1 427 031
- DE-U1-202005 006 126
- JP-A- 2005 051 840
- US-A1- 2011 057 543

## Beschreibung

Die Erfindung betrifft ein Ventil zur Steuerung eines Fluides, mit einer piezoelektrischen Aktoreinrichtung, die mindestens einen Piezowandler enthält, der über mindestens einen Piezokörper und eine diesem Piezokörper zugeordnete, sich aus zwei auf einander entgegengesetzten Seiten des Piezokörpers angeordneten Elektroden zusammensetzende und eine Gesamtkapazität aufweisende Elektrodeneinheit verfügt, wobei der Piezowandler ein Ventilglied oder ein Antriebselement für ein Ventilglied bildet.

Ein aus der DE 20 2005 006 126 U1 bekanntes Ventil dieser Art weist eine piezoelektrische Aktoreinrichtung auf, die einen als Biegewandler ausgeführten Piezowandler mit einem aus piezoelektrisch aktivem Material bestehenden Piezokörper und zwei den Piezokörper auf entgegengesetzten Längsseiten flankierenden Elektroden enthält, die gemeinsam eine Elektrodeneinheit bilden, die eine von der Grundfläche der Elektroden bestimmte Gesamtkapazität aufweist. Im Betrieb der piezoelektrischen Aktoreinrichtung wird an die Elektrodeneinheit eine Ansteuerspannung angelegt, was einen Ladungszufluss zu den beiden Elektroden zur Folge hat, woraus unter anderem eine Längenänderung des Piezokörpers resultiert. Da der Piezokörper auf einem piezoelektrisch inaktiven Substrat platziert ist, ruft die Längenänderung des Piezokörpers ein Verbiegen des Biegewandlers hervor, was zur Betätigung des Ventils genutzt wird.

Der Piezowandler kann auch als Stapeltranslator aufgebaut sein, der über mehrere aufeinandergeschichtete und jeweils von einer Elektrodeneinheit flankierte Piezokörper verfügt. Hierbei kann insbesondere eine auf dem inversen piezoelektrischen Effekt resultierende Dickenänderung der Piezokörper für Betätigungszwecke genutzt werden.

Die WO 02/089160 A2 beschreibt einen Piezowandler mit sogenanntem Multilayer-Aufbau, wobei dünne Piezokörperschichten abwechselnd mit Elektroden aufeinandergeschichtet sind, was den Vorteil hat, dass bereits mit verhältnismäßig niedrigen Ansteuerspannungen annehmbare Dehnungen des Piezomaterials und dementsprechend nennenswerte Verformungen des Piezowandlers erzielbar sind.

Aus der US 2011/0057543 A1 ist ein Vibrationsantrieb bekannt, der einen Aktuatorkörper aufweist, der aus einer gestapelten Anordnung von piezoelektrischen Schichten und internen positiven und negativen Elektrodenschichten besteht. Jede Elektrodenschicht besteht aus mehreren aufgeteilten Elektroden, sodass sich positive und negative Elektroden paarweise gegenüberliegen, die variabel elektrisch ansteuerbar sind, um den Aktuatorkörper mit hoher Frequenz zu verformen und Vibrationen zu erzeugen, mit deren Hilfe ein verschiebbar gelagertes Element hin und her bewegt werden kann. Jedes Elektrodenpaar ist unter Zwischenschaltung einer Spule an eine eigene Spannungsquelle angeschlossen.

Die EP 1 427 031 B1 offenbart ein Verfahren zur Herstellung eines piezoelektrischen Dünnschichtelementes, das über zwei zu einer Mittellinie spiegelsymmetrische Strukturen verfügt, die in einem Verbindungsbereich dadurch integral miteinander ausgebildet sind, dass zwei piezoelektrische Dünnschichten der jeweils einen Struktur mit piezoelektrischen Dünnschichten der jeweils anderen Struktur integral ausgebildet sind.

Aus der JP 2005 051840 A ist ein Verfahren bekannt, mit dem ein elektrostriktiver Aktuator mittels einer Durchkontaktierung sehr verlässlich mit einer inneren Elektrode verbindbar ist.

Grundsätzlich ist die erzielbare Dehnung eines Piezokörpers und die daraus resultierende mechanische Hubarbeit des zugehörigen Piezowandlers abhängig von der angelegten Ansteuerspannung. Insbesondere bei Anwendungen, die einen gewissen Explosionsschutz und die Einhaltung diesbezüglicher Normen erfordern, sind dem Einsatz hoher Ansteuerspannungen jedoch Grenzen gesetzt. Hohe Ansteuerspannungen führen zu hohen Strömen beim Zufluss und Abfluss der Ladungen auf die und von den Elektroden, was bei entsprechender Umgebung aufgrund von Funkenüberschlag gefährliche Explosionen nach sich ziehen kann. Um dies zu vermeiden, darf ein Piezowandler in entsprechender Umgebung nur im sogenannten eigensicheren Betrieb und mithin nur mit limitierter Ansteuerspannung betrieben werden. Dies beeinträchtigt die im Betrieb erzielbare mechanische Hubarbeit. Wird ein Piezowandler beispielsweise als Aktor zur Ventilbetätigung genutzt, führt dies in der Regel zu einer Begrenzung der steuerbaren Durchflussraten.

Der Erfindung liegt die Aufgabe zugrunde, ein Ventil mit einer piezoelektrischen Aktoreinrichtung zu schaffen, die sich auch unter Einhaltung von Explosionsschutzbestimmungen mit hoher Effektivität betreiben lässt.

Diese Aufgabe wird dadurch gelöst, dass wenigstens eine der beiden Elektroden der Elektrodeneinheit in mehrere zueinander beabstandete individuelle Teilelektroden unterteilt ist, die mit der gegenüberliegenden Elektrode mehrere jeweils eine Teilkapazität der Gesamtkapazität definierende Teilelektrodenpaare bilden, wobei zu jedem Teilelektrodenpaar ein beim Ladungsfluss wirksamer eigener Strombegrenzungswiderstand in Reihe geschaltet ist. Die piezoelektrische Aktoreinrichtung weist eine Spannungsquelle zur Bereitstellung einer der Betätigung des mindestens einen Piezowandlers dienenden Ansteuerspannung auf, mit der sämtliche Teilelektrodenpaare gleichzeitig verbunden sind. Sämtliche Teilelektrodenpaare werden aus der gleichen Spannungsquelle mit Strom versorgt, sodass an sämtliche Teilelektrodenpaare gleichzeitig die gleiche Ansteuerspannung anlegbar ist.

Der Erfindung liegt das Konzept zugrunde, bei einem Ventil die Gesamtkapazität einer einem Piezokörper zugeordneten Elektrodeneinheit auf mehrere im Vergleich zur Gesamtkapazität jeweils kleinere Teilkapazitäten aufzuteilen und jeder Teilkapazität zur Begrenzung der beim Ladungsfluss auftretenden Stromstärken einen als Strombegrenzungswiderstand bezeichenbaren Vorwiderstand zuzuordnen. Indem die Teilelektroden dazuhin beabstandet zueinander angeordnet sind, kann für jede Teilkapazität ein eigensicherer Stromkreis gewährleistet werden.

Bei einem Betrieb von Piezowandlern in explosionsgeschützter Umgebung sind in der Regel sogenannte Zündgrenzkurven zu beachten, gemäß denen die zulässige Ansteuerspannung mit zunehmender Kapazität absinkt. Grundsätzlich ist allerdings eine hohe Ansteuerspannung angestrebt, um eine möglichst hohe Ladungsdichte der Elektrodeneinheit zu erzielen und dementsprechend eine große mechanische Hubarbeit verrichten zu können.

Diesem Spagat trägt die Erfindung dadurch Rechnung, dass die dem Piezokörper zugeordnete Gesamtkapazität nicht mit nur einem Paar entsprechend großflächiger Elektroden gebildet wird, sondern quasi auf einer Zerstückelung mindestens einer großen Elektrode in mehrere kleinere Teilelektroden basiert, die nebeneinander angeordnet sind und die jeweils mit der gegenüberliegenden Gegenelektrode ein Teilelektrodenpaar bilden, dessen als Teilkapazität bezeichnete Kapazität kleiner ist als die Gesamtkapazität, wobei sich die Gesamtkapazität aus der Summe der vorhandenen Teilkapazitäten zusammensetzt. Die kleineren Teilkapazitäten können in zulässiger Weise mit höheren Ansteuerspannungen als eine große Kapazität betrieben werden, sodass auf die Elektrodeneinheit insgesamt eine größere Ladung aufgebracht werden kann als bei einem einzelnen, sehr großflächigen Elektrodenpaar. Da alle Teilkapazitäten über den zugeordneten Piezokörper, der bevorzugt einteilig und insbesondere einstückig ausgebildet ist, mechanisch miteinander verkoppelt sind, verhält sich die sich aus den Teilelektrodenpaaren und dem Piezokörper zusammensetzende Piezoeinheit wie ein konventioneller Piezowandler, der beidseits von jeweils nur einer einzigen Elektrode flankiert ist. Die schaltungstechnisch in Reihe mit den Teilelektrodenpaaren angeordneten Strombegrenzungswiderstände sorgen dafür, dass die Stromstärke beim Ladungsfluss ein zulässiges Maß nicht überschreitet, wobei die damit einhergehende geringfügig höhere Zeitkonstante bis zur vollen Aufladung der Teilelektrodenpaare sehr gering ist und sich auf das Betriebsverhalten nicht nennenswert auswirkt. Da der erfindungsgemäße Piezowandler bis auf die zusätzlichen Widerstände und die höhere Ansteuerspannung in der Regel keine weiteren Anforderungen an die zugeordnete Treiberelektronik stellt, kann ein universeller Einsatz in nahezu allen Fällen gewährleistet werden, in denen bisher konventionell aufgebaute Piezowandler eingesetzt werden.

Das erfindungsgemäße Prinzip kann bei Piezowandlern beliebigen Typs realisiert werden. Nur beispielhaft seien Anwendungen bei Monomorph-Piezowandlern, Trimorph-Biegewandlern und/oder Biegewandlern mit Multilayer-Aufbau erwähnt. Ferner eignet sich das erfindungsgemäße Prinzip insbesondere sowohl bei Biegewandlern als auch bei Stapeltranslatoren.

Vorteilhafte Weiterbildungen der Erfindung gehen aus den Unteransprüchen hervor.

Ein besonders kostengünstiger Aufbau sieht vor, dass nur eine der beiden Elektroden der einem Piezokörper zugeordneten Elektrodeneinheit in mehrere zueinander beabstandete individuelle Teilelektroden unterteilt ist, während die auf der anderen Seite des Piezokörpers liegende Elektrode als einheitliche, also zusammenhängende und insbesondere einstückige Elektrode ausgeführt ist. Hier bilden dann die den individuellen Teilelektroden gegenüberliegenden Elektrodenabschnitte der einheitlichen Elektrode die auf dieser Seite angeordneten Teilelektroden.

Wenn der Piezokörper bei entsprechendem Aufbau des Piezowandlers auf einem piezoelektrisch inaktiven Substrat angeordnet ist, besteht die vorteilhafte Möglichkeit, ein elektrisch leitfähiges Substrat zu verwenden, das dann unmittelbar als die einheitliche Elektrode genutzt werden kann.

Der erfindungsgemäße Effekt lässt sich allerdings auch dann vorteilhaft erzielen, wenn beide Elektroden der Elektrodeneinheit in mehrere zueinander beabstandete individuelle Teilelektroden unterteilt sind, sodass sich individuelle Teilelektroden beider Elektroden unter Bildung individueller Teilelektrodenpaare paarweise gegenüberliegen. In diesem Zusammenhang ist es vorteilhaft, wenn die Anzahl der auf beiden Seiten des Piezokörpers vorhandenen Teilelektroden gleichgroß ist und jeder individuellen Teilelektrode der einen Seite eine einzige individuelle Teilelektrode der anderen Seite gegenüberliegt.

Es ist ferner vorteilhaft, wenn die sich unter Bildung eines individuellen Teilelektrodenpaares jeweils gegenüberliegenden individuellen Teilelektroden jeweils gleichgroß sind was die Elektrodenfläche anbelangt.

Zweckmäßigerweise sind die zur jeweils gleichen Elektrode gehörenden individuellen Teilelektroden in einer gemeinsamen Ebene angeordnet.

In einer bevorzugten Gestaltung sind die individuellen Teilelektroden streifenförmig ausgebildet und mit Querabstand längsseits nebeneinander angeordnet. Besonders zweckmäßig ist dies bei einer Ausgestaltung des Piezowandlers als länglicher Biegewandler, wobei dann die individuellen Teilelektroden insbesondere quer zur Längsrichtung des Biegewandlers mit Abstand zueinander angeordnet sind.

Allerdings stellt sich der erfindungsgemäße Erfolg bei jedem beliebigen Verteilungsmuster der Teilelektrodenpaare ein. So können beispielsweise bei einem eine Längsgestalt aufweisenden Biegewandler mehrere Teilelektrodenpaare auch in der Längsrichtung des Biegewandlers aufeinanderfolgend mit Abstand zueinander angeordnet sein.

Wie schon angesprochen, ist der Piezokörper insbesondere bei einem Aufbau des Piezowandlers als Biegewandler auf einem piezoelektrisch inaktiven und bevorzugt federelastischen Substrat angeordnet. Dieses Substrat kann, wenn es elektrisch leitfähig ist, eine einheitliche Elektrode der Elektrodeneinheit bilden, die abschnittsweise mit individuellen Teilelektroden auf der entgegengesetzten Seite des Piezokörpers zur Bildung von Teilkapazitäten zusammenwirkt.

Bevorzugt ist jedes Teilelektrodenpaar mit einem dem elektrischen Ladungstransport dienenden eigenen elektrischen Anschlussleiter kontaktiert, in dessen Verlauf der zugeordnete, in Reihe geschaltete Strombegrenzungswiderstand eingeschaltet ist.

Eine bevorzugte Ausgestaltung der piezoelektrischen Aktoreinrichtung enthält außer dem mindestens einen Piezowandler eine Spannungsquelle zur Bereitstellung einer die Betätigung des mindestens einen Piezowandlers ermöglichenden Ansteuerspannung, die mit sämtlichen Teilelektrodenpaaren gleichzeitig verbunden oder verbindbar ist.

Nachfolgend wird die Erfindung anhand der beiliegenden Zeichnung näher erläutert. In dieser zeigen:
- Figur 1: eine bevorzugte Ausführungsform der piezoelektrischen Aktoreinrichtung in einer schematischen isometrischen Darstellung,
- Figur 2: eine andere Ansicht der Aktoreinrichtung aus Figur 1 mit Blick gemäß Pfeil II auf eine Stirnseite des Piezowandlers, und
- Figur 3: eine weitere Ausführungsform der piezoelektrischen Aktoreinrichtung in einer Ansicht entsprechend Figur 2.

Die in ihrer Gesamtheit mit Bezugsziffer 1 bezeichnete piezoelektrische Aktoreinrichtung enthält mindestens einen und bei beiden Ausführungsbeispielen jeweils genau einen Piezowandler 2, der in der Lage ist, elektrische Energie in mechanische Energie umzuwandeln. Der Piezowandler 2 kann beispielsweise als Aktor zur Betätigung von beliebigen Organen genutzt werden. Ein vorteilhafter Einsatz ist die Verwendung in einem zur Steuerung eines Fluides dienenden Ventil und dort unmittelbar als Ventilglied oder als Antriebselement für ein Ventilglied.

Zweckmäßigerweise ist bei einem Einsatz als Ventil das von dem Piezowandler 2 gebildete oder angetriebene Ventilglied durch Betätigung des Piezowandlers 2 bewegbar, um mit mindestens einem Ventilsitz zusammenzuwirken und dadurch die Strömung eines Fluides zu beeinflussen. Bevorzugt umrahmt der Ventilsitz die Mündung eines Ventilkanals, die verschlossen ist, wenn das Ventilglied an dem Ventilsitz anliegt und die offen ist, wenn das Ventilglied von dem Ventilsitz abgehoben ist. Der Ventilsitz ist zweckmäßigerweise an einem Ventilgehäuse des Ventils angeordnet, das eine Ventilkammer definiert, in der sich das Ventilglied erstreckt, wobei das Ventilglied durch Betätigung des Piezowandlers 2 zumindest bereichsweise relativ zum Ventilgehäuse bewegbar ist, um seine Relativposition bezüglich des Ventilsitzes zu verändern.

Die Gestalt des Piezowandlers 2 ist im Hinblick auf die Erfindung grundsätzlich irrelevant. Beim Ausführungsbeispiel hat er eine längliche Gestalt mit einer Längsachse 3. Hiervon abweichend kann er beispielsweise auch plattenförmig oder scheibenförmig konzipiert sein.

Weiterhin illustriert die Zeichnung einen bevorzugt als Biegewandler ausgebildeten Piezowandler 2. Die Erfindung ist allerdings auch bei anderen Piezowandlerarten anwendbar, beispielsweise bei sogenannten Stapeltranslatoren.

Der Piezowandler 2 verfügt über mindestens einen aus einem piezoelektrisch aktiven Material und insbesondere aus einer Piezokeramik bestehenden Piezokörper 4. Dieser Piezokörper 4 ist bei den Ausführungsbeispielen streifenförmig ausgebildet, jedoch könnte er auch in Abhängigkeit vom Typ des Piezowandlers 2 plattenförmig oder scheibenförmig gestaltet sein.

Der Piezokörper 4 hat zwei voneinander abgewandte, einander entgegengesetzt orientierte großflächige Oberflächen, die im Folgenden zur besseren Unterscheidung als Oberseite 5 und als Unterseite 6 bezeichnet werden, ohne dass damit eine Einschränkung verbunden sein soll. Der Piezowandler 2 kann ohne weiteres mit beliebiger Orientierung der Oberseite 5 und Unterseite 6 betrieben werden.

Der Piezokörper 4 verfügt über eine Hauptausdehnungsebene 7, bezüglich der die Oberseite 5 und Unterseite 6 parallel verlaufen. Exemplarisch hat der streifenförmige Piezokörper 4 eine Längsachse 8, die gleich wie die Längsachse 3 des Piezowandlers 2 orientiert ist und die parallel zu der Hauptausdehnungsebene 7 verläuft.

Der Piezokörper 4 ist sandwichartig zwischen zwei Elektroden 12, 13 angeordnet, die im Folgenden zur besseren Unterscheidung als erste und zweite Elektroden 12, 13 bezeichnet werden. Die erste Elektrode 12 ist der Oberseite 5 zugeordnet, die zweite Elektrode 13 der Unterseite 6. Jede Elektrode 12, 13 besteht aus einem elektrisch leitfähigen Material.

Bevorzugt ist mindestens eine und zweckmäßigerweise jede Elektrode 12, 13 direkt auf den Piezokörper 4 aufgebracht. Beim Ausführungsbeispiel ist die erste Elektrode 12 an der Oberseite 5 angebracht und die zweite Elektrode 13 an der Unterseite 6. Mindestens eine der beiden Elektroden 12, 13 kann beispielsweise als Metallisierung auf den Piezokörper 4 aufgebracht sein.

Die beiden Elektroden 12, 13 bilden gemeinsam eine Elektrodeneinheit 14, die eine gewisse, als Gesamtkapazität bezeichnete Ladungskapazität definiert. Über eine elektrische Leiteranordnung 15, die zweckmäßigerweise zu der piezoelektrischen Aktoreinrichtung 1 gehört, sind die beiden Elektroden 12, 13 mit einer bevorzugt ebenfalls zu der piezoelektrischen Aktoreinrichtung 1 gehörenden Spannungsquelle 16 verbunden oder verbindbar. Exemplarisch handelt es sich um eine schaltbare Spannungsquelle, die über geeignete Schaltmittel 16a verfügt, die es ermöglichen, wahlweise eine Ansteuerspannung an die Elektrodeneinheit 14 anzulegen oder von der Elektrodeneinheit 14 abzutrennen. Zweckmäßigerweise sind der Spannungsquelle 16 auch noch nicht weiter abgebildete elektrische und/oder elektronische Schaltungsmittel zugeordnet, die insbesondere eine Treiberelektronik bilden und die bei Bedarf zweckmäßigerweise auch einen Ladungsabfluss von der Elektrodeneinheit 14 hervorrufen können, um die Gesamtkapazität wieder zu entladen.

Wenn an die Elektrodeneinheit 14 eine Ansteuerspannung angelegt wird, fließen Ladungen auf die beiden Elektroden 12, 13 und erzeugen zwischen den beiden Elektroden 12, 13 ein durch Doppelpfeile angedeutetes elektrisches Feld 19, das den Piezokörper 4 quer zu seiner Hauptausdehnungsebene 7 durchsetzt. Dies führt gemäß dem inversen piezoelektrischen Effekt zu einer Formänderung des Piezokörpers 4, die beim Ausführungsbeispiel insbesondere auch eine Verformung in der Längsrichtung 8 zur Folge hat. Dies wiederum führt bei beiden Ausführungsbeispielen zu einem Verbiegen des Piezowandlers 2 rechtwinkelig zu der Hauptausdehnungsebene 7.

Das Biegeverhalten des Piezowandlers 2 resultiert bei beiden Ausführungsbeispielen aus dem Umstand, dass der Piezokörper 4 mit seiner Unterseite 6 auf einem piezoelektrisch inaktiven Substrat 17 befestigt ist, das die Längendehnung des Piezokörpers 4 nicht mitmachen kann. Es besteht vorzugsweise aus einem federelastischen Material, beispielsweise aus Metall, aus Kunststoffmaterial oder aus einem Verbundmaterial. Bevorzugt ist es wie der Piezokörper 4 gestaltet und hat deshalb beim Ausführungsbeispiel eine Streifenform.

Das Substrat 17 kompensiert die Längsdehnung des Piezokörpers 4 durch ein Verkrümmen. Dies führt insgesamt zu dem schon erwähnten Durchbiegen des Piezowandlers 2 bei seiner Bestromung.

Ist der Piezowandler 2 als Stapeltranslator ausgebildet, entfällt in der Regel das Substrat 17. In diesem Fall sind mehrere Piezokörper 4 rechtwinkelig zu der Hauptausdehnungsebene 7 aufeinandergestapelt, im Wechsel mit jeweils einer Elektrode. Auf diese Weise ist wiederum jeder Piezokörper 4 von zwei eine Elektrodeneinheit 14 bildenden Elektroden 12, 13 flankiert, wobei allerdings jede zwischen zwei Piezokörpern 4 angeordnete Elektrode gleichzeitig eine Elektrode beider benachbarten Elektrodeneinheiten 14 bildet. Dies gilt im Übrigen auch für einen Piezowandler 2, dessen piezoelektrisch aktiver Abschnitt in einer sogenannten Multilayer-Bauform konzipiert ist und sich aus mehreren abwechselnd aufeinandergeschichteten Piezokörpern 4 und Elektroden 12, 13 zusammensetzt.

Ein vorteilhafter Effekt resultiert bei allen gezeigten und erwähnten Ausführungsbeispielen der piezoelektrischen Aktoreinrichtung 1 aus dem Umstand, dass die Elektrodeneinheit 14 in mehrere Teilelektrodenpaare 18 unterteilt ist, die alle mechanisch mit dem Piezokörper 4 gekoppelt und insbesondere fest verbunden sind. Jedes dieser mehreren Teilelektrodenpaare 18, die auf dem Piezokörper 4 zweckmäßigerweise elektrisch voneinander isoliert sind, definiert eine Ladungskapazität, die kleiner ist als die oben erwähnte Gesamtkapazität und die deshalb als Teilkapazität bezeichnet wird. Die Summe der Teilkapazitäten der vorhandenen mehreren Teilelektrodenpaare 18 ergibt die Gesamtkapazität der Elektrodeneinheit 14.

Bei den gezeigten Ausführungsbeispielen sind jeweils drei Teilelektrodenpaare 18 realisiert. Der erfindungsgemäße Effekt stellt sich allerdings auch schon bei nur zwei Teilelektrodenpaaren 18 ein. Ohne weiteres kann der Piezokörper auch mit mehr als drei Teilelektrodenpaaren 18 ausgestattet sein.

Die Teilelektrodenpaare 18 resultieren daraus, dass wenigstens eine der beiden Elektroden 12, 13 in mehrere zueinander beabstandete individuelle Teilelektroden 12a, 13a unterteilt ist, die mit der jeweils gegenüberliegenden anderen Elektrode ein Teilelektrodenpaar 18 bilden. Die zur gleichen Elektrode 12 oder 13 gehörenden Teilelektroden 12a oder 13a sind einander gegenüber bevorzugt elektrisch isoliert.

Die individuellen Teilelektroden 12a, 13a liegen pro Elektrode 12, 13 zweckmäßigerweise in der Hauptausdehnungsebene 7 mit Abstand nebeneinander. Zur gleichen Elektrode 12 oder 13 gehörende individuelle Teilelektroden 12a, 13a liegen bevorzugt in einer gemeinsamen Ebene.

Der zwischen benachbarten Teilelektroden 12a, 13a der gleichen Elektrode 12, 13 vorhandene Zwischenraum 22 ist ausreichend groß bemessen, um im Betrieb ein Auftreten von Kriechströmen oder einen Funkenüberschlag auszuschließen. Der Zwischenraum 22 kann luftgefüllt oder mit einem elektrisch nichtleitenden Material ausgefüllt sein. Der Abstand zwischen benachbarten Teilelektroden 12a, 13a der gleichen Elektrode 12, 13 ist jeweils groß genug, um die Eigensicherheit gemäß den einschlägigen Explosionsschutznormen zu gewährleisten.

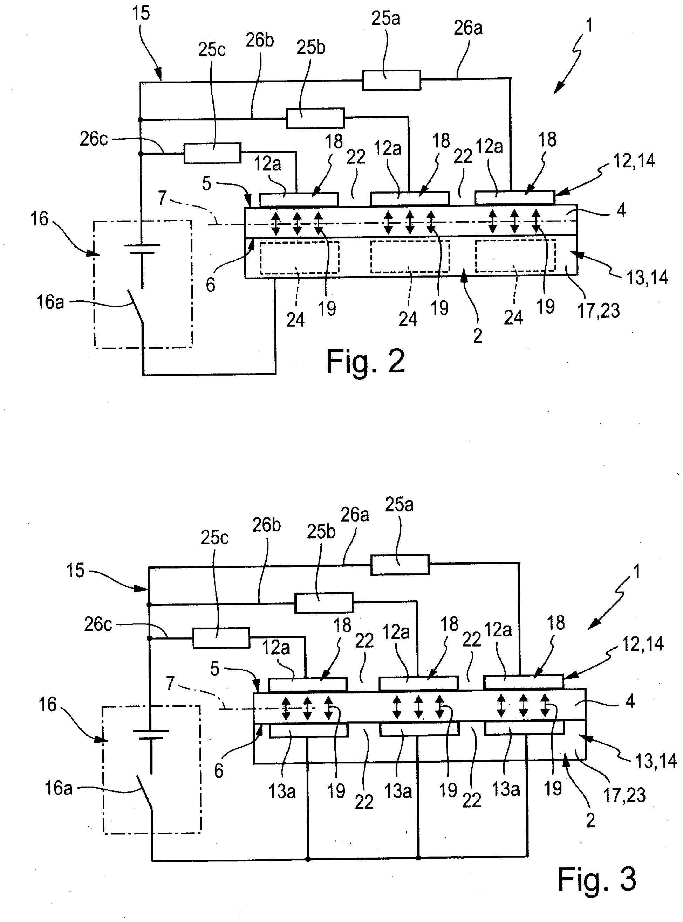

Bei dem Ausführungsbeispiel der Figur 3 sind beide Elektroden 12, 13 der Elektrodeneinheit 14 jeweils in mehrere zueinander beabstandete individuelle Teilelektroden 12a, 13a unterteilt. Dabei liegen sich individuelle Teilelektroden 12a, 13a beider Elektroden 12, 13 unter Bildung von Teilelektrodenpaaren 18 paarweise in der Dickenrichtung des Piezokörpers 4, also rechtwinkelig zu der Hauptausdehnungsebene 7, gegenüber. Vorzugsweise enthält die Elektrodeneinheit 14 eine gleichgroße Anzahl von individuellen Teilelektroden 12a und 13a. In diesem Zusammenhang liegt jeder individuellen Teilelektrode 12a der einen Elektrode 12 eine individuelle Teilelektrode 13a der anderen Elektrode 13 gegenüber. Die sich gegenüberliegenden Teilelektroden 12a, 13a sind zweckmäßigerweise gleichgroß und haben insbesondere den gleichen Grundriss, sodass sie sich überdecken, wenn man den Piezowandler 2 in der Dickenrichtung des Piezokörpers 4 betrachtet.

Auch wenn die zum gleichen Teilelektrodenpaar 18 gehörenden Teilelektroden 12a, 13a gleichgroß sind, besteht doch die Möglichkeit, die Größe der Teilelektroden 12a, 13a bei mehreren Teilelektrodenpaaren 18 unterschiedlich zu wählen. So kann beispielsweise die Grundfläche der Teilelektroden 12a, 13a eines ersten Teilelektrodenpaares 18 größer sein als die Grundfläche der Teilelektroden 12a, 13a mindestens eines weiteren Teilelektrodenpaares 18.

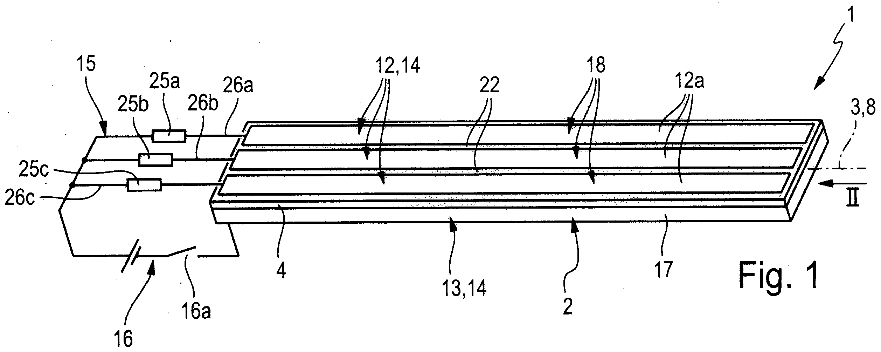

Bei dem in Figuren 1 und 2 illustrierten Ausführungsbeispiel besteht nur die erste Elektrode 12 aus mehreren individuellen Teilelektroden 12a, 13a. Die zweite Elektrode 13 hingegen ist als einheitliche Elektrode 23 ausgebildet, die keine Unterteilung aufweist und die insbesondere eine zusammenhängende flächenhafte Ausdehnung aufweist, die bevorzugt mindestens so groß ist wie die Summe der Grundflächen der auf der anderen Seite angeordneten individuellen Teilelektroden 12a und der diesen zugeordneten Zwischenräume 22.

In diesem Fall ist jedes Teilelektrodenpaar 18 gebildet von einer der individuellen Teilelektroden 12a der einen Elektrode 12 und dem dieser individuellen Teilelektrode 12a gegenüberliegenden, in Figur 2 gepunktet angedeuteten Elektrodenabschnitt 24 der einheitlichen Elektrode 23. Diese Bauform hat den Vorteil einer besonders einfachen Herstellung, weil sich an der einen Seite des Piezokörpers 4 eine Bestückung mit individuellen Teilelektroden erübrigt.

Von Vorteil ist es, wenn das gegebenenfalls vorhandene, piezoelektrisch inaktive Substrat 17 elektrisch leitfähig ausgebildet ist, da dann dieses Substrat 17 unmittelbar selbst als einheitliche Elektrode 23 verwendbar ist. In diesem Fall erspart man sich die gesonderte Applikation einer entsprechenden Elektrode. Beim Ausführungsbeispiel der Figuren 1 und 2 ist dies der Fall.

Es besteht allerdings ohne weiteres die Möglichkeit, die zweite Elektrode 13 zusätzlich zu dem piezoelektrisch inaktiven Substrat 17 vorzusehen. Eine solche Bauform liegt beim Ausführungsbeispiel der Figur 3 vor. In diesem Fall ist die zweite Elektrode 13 zweckmäßigerweise zwischen dem Piezokörper 4 und dem piezoelektrisch inaktiven Substrat 17 angeordnet. Besonders sinnvoll ist diese Bauform vor allem dann, wenn auch die zweite Elektrode 13 wie die erste Elektrode 12 in Form mehrerer individueller Teilelektroden 13a verwirklicht ist.

Der Piezokörper 4 ist zweckmäßigerweise einteilig und insbesondere einstückig ausgebildet.

Insbesondere in Verbindung mit einem als Biegewandler ausgebildeten Piezowandler 2 ist es zweckmäßig, mehrere und insbesondere sämtliche individuellen Teilelektroden 12a, 13a streifenförmig mit Längsgestalt auszubilden und derart am Piezokörper 4 anzuordnen, dass sie sich in Achsrichtung dessen Längsachse 8 erstrecken und mit Querabstand längsseits nebeneinander angeordnet sind. Dies trifft auf beide Ausführungsbeispiele zu.

Zu jedem Teilelektrodenpaar 18 ist ein eigener Strombegrenzungswiderstand 25a, 25b, 25c in Reihe geschaltet, sodass jeder Strombegrenzungswiderstand 25a, 25b, 25c insbesondere beim Ladungszufluss zu den Teilelektrodenpaaren 18, vorzugsweise aber auch beim Ladungsabfluss von diesen Teilelektrodenpaaren 18, vom elektrischen Strom durchflossen wird. Auf diese Weise erfolgt pro Teilkapazität eine Begrenzung der Stromstärke auf ein Maß, das einen Einsatz der piezoelektrischen Aktoreinrichtung 1 auch in explosionsgefährdeten Bereichen gestattet. Jeder der Strombegrenzungswiderstände 25a, 25b, 25c ist ein rein ohmscher Widerstand. Man kann somit auch von einer resistiven Strombegrenzung sprechen. Der Widerstandwert beträgt pro Strombegrenzungswiderstand 25a, 25b, 25c zweckmäßigerweise mehrere Kiloohm.

Exemplarisch ist jedes Teilelektrodenpaar 18 mit einem dem elektrischen Ladungstransport dienenden eigenen elektrischen Anschlussleiter 26a, 26b, 26c kontaktiert, in dessen Verlauf der zugeordnete Strombegrenzungswiderstand 25a, 25b, 25c eingeschaltet ist und der ein Bestandteil der schon erwähnten elektrischen Leiteranordnung 15 ist. Diese elektrischen Anschlussleiter 26a, 26b, 26c sind zweckmäßigerweise gemeinsam an die Spannungsquelle 16 angeschlossen. Somit sind alle Teilelektrodenpaare 18 an die gleiche Spannungsquelle 16 angeschlossen. Indem die Spannungsquelle 16 schaltbar ist, besteht die Möglichkeit, sämtliche Teilelektrodenpaare 18 gleichzeitig an die Ansteuerspannung anzulegen oder von dieser abzutrennen. Die Aktoreinrichtung 1 wird bevorzugt derart betrieben, dass an sämtliche Teilelektrodenpaare 18 jeweils gleichzeitig die gleiche Ansteuerspannung angelegt wird.

## Patentansprüche

1. Ventil zur Steuerung eines Fluides, mit einer piezoelektrischen Aktoreinrichtung (1), die mindestens einen Piezowandler (2) enthält, der über mindestens einen Piezokörper (4) und eine diesem Piezokörper (4) zugeordnete, sich aus zwei auf einander entgegengesetzten Seiten des Piezokörpers (4) angeordneten Elektroden (12, 13) zusammensetzende und eine Gesamtkapazität aufweisende Elektrodeneinheit (14) verfügt, wobei der Piezowandler (2) ein Ventilglied oder ein Antriebselement für ein Ventilglied bildet, wobei wenigstens eine der beiden Elektroden (12, 13) der Elektrodeneinheit (14) in mehrere zueinander beabstandete individuelle Teilelektroden (12a, 13a) unterteilt ist, die mit der gegenüberliegenden Elektrode (13, 12) mehrere jeweils eine Teilkapazität der Gesamtkapazität definierende Teilelektrodenpaare (18) bilden, wobei zu jedem Teilelektrodenpaar (18) ein beim Ladungsfluss wirksamer eigener Strombegrenzungswiderstand (25a, 25b, 25c) in Reihe geschaltet ist, wobei die Aktoreinrichtung (1) eine Spannungsquelle (16) zur Bereitstellung einer der Betätigung des mindestens einen Piezowandlers (2) dienenden Ansteuerspannung aufweist, mit der sämtliche Teilelektrodenpaare (18) gleichzeitig verbunden sind, wobei sämtliche Teilelektrodenpaare (18) aus der gleichen Spannungsquelle (16) mit Strom versorgt werden, sodass an sämtliche Teilelektrodenpaare (18) gleichzeitig die gleiche Ansteuerspannung anlegbar ist.

2. Ventil nach Anspruch 1, **dadurch gekennzeichnet, dass** nur eine der beiden Elektroden (12) der Elektrodeneinheit (14) in mehrere zueinander beabstandete individuelle Teilelektroden (12a) unterteilt ist, während die gegenüberliegende andere Elektrode (13) eine einheitliche Elektrode (23) ist und den individuellen Teilelektroden (12a, 13a) gegenüberliegende Elektrodenabschnitte (24) der einheitlichen Elektrode (23) zur Bildung jeweils eines Teilelektrodenpaars (18) beitragen.

3. Ventil nach Anspruch 1, **dadurch gekennzeichnet, dass** beide Elektroden (12, 13) der Elektrodeneinheit (14) in mehrere zueinander beabstandete individuelle Teilelektroden (12a, 13a) unterteilt sind, wobei sich individuelle Teilelektroden (12a, 13a) beider Elektroden (12, 13) unter Bildung von Teilelektrodenpaaren (18) paarweise gegenüberliegen.

4. Ventil nach Anspruch 3, **dadurch gekennzeichnet, dass** die beiden Elektroden (12, 13) in eine gleichgroße Anzahl von individuellen Teilelektroden (12a, 13a) unterteilt sind, wobei jeder individuellen Teilelektrode (12a, 13a) der einen Elektrode (12, 13) unter Bildung eines Teilelektrodenpaares (18) eine individuelle Teilelektrode (13a, 12a) der anderen Elektrode (13, 12) gegenüberliegt.

5. Ventil nach Anspruch 3 oder 4, **dadurch gekennzeichnet, dass** die sich unter Bildung eines Teilelektrodenpaares (18) jeweils gegenüberliegenden individuellen Teilelektroden (12a, 13a) gleichgroß sind.

6. Ventil nach einem der Ansprüche 1 bis 5, **dadurch gekennzeichnet, dass** die zur gleichen Elektrode (12, 13) gehörenden individuellen Teilelektroden (12a, 13a) in einer gemeinsamen Ebene liegen.

7. Ventil nach einem der Ansprüche 1 bis 6, **dadurch gekennzeichnet, dass** mehrere und zweckmäßigerweise sämtliche individuellen Teilelektroden (12a, 13a) jeder in individuelle Teilelektroden (12a, 13a) unterteilten Elektrode (12, 13) streifenförmig ausgebildet und mit Querabstand längsseits nebeneinander angeordnet sind.

8. Ventil nach einem der Ansprüche 1 bis 7, **dadurch gekennzeichnet, dass** der Piezowandler (2) als eine Längsgestalt aufweisender Biegewandler ausgebildet ist, wobei die individuellen Teilelektroden (12a, 13a) jeder in individuelle Teilelektroden (12a, 13a) unterteilten Elektrode (12, 13) quer zur Längsrichtung des Biegewandlers mit Abstand nebeneinander angeordnet sind.

9. Ventil nach einem der Ansprüche 1 bis 8, **dadurch gekennzeichnet, dass** der mindestens eine Piezokörper (4) einteilig und insbesondere einstückig ausgebildet ist.

10. Ventil nach einem der Ansprüche 1 bis 9, **dadurch gekennzeichnet, dass** der Piezokörper (4) auf einem piezoelektrisch inaktiven, zweckmäßigerweise federelastischen Substrat (17) angeordnet ist.

11. Ventil nach Anspruch 10, **dadurch gekennzeichnet, dass** das piezoelektrisch inaktive Substrat (17) elektrisch leitfähige Eigenschaften hat und unmittelbar eine einheitliche Elektrode (23) der Elektrodeneinheit (14) bildet.

12. Ventil nach einem der Ansprüche 1 bis 11, **dadurch gekennzeichnet, dass** jedes Teilelektrodenpaar (18) mit einem dem elektrischen Ladungstransport dienenden eigenen elektrischen Anschlussleiter (26a, 26b, 26c) kontaktiert ist, in dessen Verlauf der zugeordnete, in Reihe geschaltete Strombegrenzungswiderstand (25a, 25b, 25c) eingeschaltet ist.

## Claims

1. Valve for the control of a fluid, with a piezoelectric actuator device (1) containing at least one piezoelectric actuator (2), which has at least one piezoelectric body (4) and an electrode unit (14) assigned to this piezoelectric body (4), with overall capacitance and comprised of two electrodes (12, 13) mounted on opposite sides of the piezoelectric body (4), wherein the piezoelectric actuator (2) forms a valve member or a drive element for a valve member, wherein at least one of the two electrodes (12, 13) of the electrode unit (14) is divided into several individual sub-electrodes (12a, 13a), spaced apart from one another and forming with the electrode (13, 12) lying opposite several sub-electrode pairs (18) defining in each case a partial capacitance of the overall capacitance, wherein a separate current-limiting resistor (25a, 25b, 25c) active during charge flow is connected in series to each sub-electrode pair (18), wherein the actuator device (1) has a voltage source (16) to provide a drive voltage allowing actuation of the piezoelectric actuator or actuators (2) and to which all sub-electrode pairs (18) are connected simultaneously, wherein all sub-electrode pairs (18) are supplied with current from the same voltage source (16), so that the same drive voltage may be applied to all sub-electrode pairs (18) simultaneously.

2. Valve according to claim 1, **characterised in that** only one of the two electrodes (12) of an electrode unit (14) is divided into several individual sub-electrodes (12a), spaced apart from one another, while the other electrode (13) lying opposite is a unitary electrode (23) and the electrode sections (24) of the unitary electrode (23) lying opposite the individual sub-electrodes (12a, 13a) contribute to forming a sub-electrode pair (18) in each case.

3. Valve according to claim 1, **characterised in that** both electrodes (12, 13) of the electrode unit (14) are divided into several individual sub-electrodes (12a, 13a), spaced apart, wherein individual sub-electrodes (12a, 13a) of both electrodes (12, 13) lie opposite in pairs to form sub-electrode pairs (18).

4. Valve according to claim 3, **characterised in that** the two electrodes (12, 13) are divided into an equal number of individual sub-electrodes (12a, 13a), wherein each individual sub-electrodes (12a, 13a) of the one electrode (12, 13) lies opposite an individual sub-electrode (13a, 12a) of the other electrode (13, 12) to form a sub-electrode pair (18).

5. Valve according to claim 3 or 4, **characterised in that** the individual sub-electrodes (12a, 13a) lying opposite one another to form a sub-electrode pair (18) are in each case of equal size.

6. Valve according to any of claims 1 to 5, **characterised in that** the individual sub-electrodes (12a, 13a) belonging to the same electrodes (12, 13) lie in a common plane.

7. Valve according to any of claims 1 to 6, **characterised in that** several and expediently all individual sub-electrodes (12a, 13a) of each electrode (12, 13) divided into individual sub-electrodes (12a, 13a) are strip-shaped and arranged next to one another, on the long side and with lateral clearance.

8. Valve according to any of claims 1 to 7, **characterised in that** the piezoelectric actuator (2) is in the form of a bending actuator with an elongated shape, wherein the individual sub-electrodes (12a, 13a) of each electrode (12, 13) divided into individual sub-electrodes (12a, 13a) are arranged transversely to the axial direction of the bending actuator, next to and with clearance from one another.

9. Valve according to any of claims 1 to 8, **characterised in that** the piezoelectric body or bodies (4) is or are a single part and in particular made in one piece.

10. Valve according to any of claims 1 to 9, **characterised in that** the piezoelectric body (4) is mounted on a piezoelectrically inactive, expediently spring-elastic substrate (17).

11. Valve according to claim 10, **characterised in that** the piezoelectrically inactive substrate (17) has electrically conductive properties and directly forms a unitary electrode (23) of the electrode unit (14).

12. Valve according to any of claims 1 to 11, **characterised in that** each sub-electrode pair (18) is contacted by a separate electrical supply lead (26a, 26b, 26c) serving for electrical charge transfer and containing the assigned current-limiting resistor (25a, 25b, 25c) connected in series.

## Revendications

1. Soupape de commande d'un fluide, avec un dispositif actionneur piézoélectrique (1) qui contient au moins un convertisseur piézoélectrique (2) qui dispose d'au moins un corps piézoélectrique (4) et d'une unité d'électrodes (14) affectée à ce corps piézoélectrique (4), composée de deux électrodes (12, 13) disposées sur des côtés opposés l'un à l'autre du corps piézoélectrique (4) et présentant une capacité totale, dans laquelle le convertisseur piézoélectrique (2) forme un élément de soupape ou un élément d'entraînement pour un élément de soupape, dans laquelle au moins une des deux électrodes (12, 13) de l'unité d'électrodes (14) est divisée en plusieurs électrodes partielles individuelles (12a, 13a) espacées les unes des autres, qui forment avec l'électrode (13, 12) située en vis-à-vis plusieurs paires d'électrodes partielles (18) définissant chacune une capacité partielle de la capacité totale, dans laquelle une résistance de limitation de courant (25a, 25b, 25c) propre active pendant le flux de charge est montée en série pour chaque paire d'électrodes partielles (18), dans laquelle le dispositif actionneur (1) présente une source de tension (16) pour la fourniture d'une tension de commande servant à actionner l'au moins un convertisseur piézoélectrique (2), à laquelle toutes les paires d'électrodes partielles (18) sont reliées simultanément, dans laquelle toutes les paires d'électrodes partielles (18) de la même source de tension (16) sont alimentées en courant de sorte que la même tension de commande puisse être appliquée simultanément à toutes les paires d'électrodes partielles (18).

2. Soupape selon la revendication 1, **caractérisée en ce qu'**une seule des deux électrodes (12) de l'unité d'électrodes (14) est divisée en plusieurs électrodes partielles individuelles (12a) espacées les unes des autres, tandis que l'autre électrode (13) située en vis-à-vis est une électrode unitaire (23) et **en ce que** des sections d'électrodes (24) de l'électrode unitaire (23) situées en vis-à-vis des électrodes partielles individuelles (12a, 13a) contribuent à former chacune une paire d'électrodes partielles (18).

3. Soupape selon la revendication 1, **caractérisée en ce que** les deux électrodes (12, 13) de l'unité d'électrodes (14) sont divisées en plusieurs électrodes partielles individuelles (12a, 13a) espacées les unes des autres, dans laquelle des électrodes partielles individuelles (12a, 13a) des deux électrodes (12, 13) sont situées en vis-à-vis par paires pour former des paires d'électrodes partielles (18).

4. Soupape selon la revendication 3, **caractérisée en ce que** les deux électrodes (12, 13) sont divisées en un nombre uniforme d'électrodes partielles individuelles (12a, 13a), dans laquelle chaque électrode partielle individuelle (12a, 13a) d'une électrode (12, 13) est située en vis-à-vis d'une électrode partielle individuelle (13a, 12a) de l'autre électrode (13, 12) pour former une paire d'électrodes partielles (18).

5. Soupape selon la revendication 3 ou 4, **caractérisée en ce que** les électrodes partielles individuelles (12a, 13a) situées chacune en vis-à-vis pour former une paire d'électrodes partielles (18) sont de même taille.

6. Soupape selon l'une des revendications 1 à 5, **caractérisée en ce que** les électrodes partielles individuelles (12a, 13a) appartenant à la même électrode (12, 13) se situent sur un plan commun.

7. Soupape selon l'une des revendications 1 à 6, **caractérisée en ce que** plusieurs et, de manière appropriée, toutes les électrodes partielles individuelles (12a, 13a) de chaque électrode (12, 13) divisée en électrodes partielles individuelles (12a, 13a) sont réalisées en forme de bande et disposées les unes à côté des autres dans le sens de la longueur avec un espace transversal.

8. Soupape selon l'une des revendications 1 à 7, **caractérisée en ce que** le convertisseur piézoélectrique (2) est réalisé comme transducteur de flexion présentant une forme allongée, dans laquelle les électrodes partielles individuelles (12a, 13a) de chaque électrode (12, 13) divisée en électrodes partielles individuelles (12a, 13a) sont disposées à distance les unes à côté des autres transversalement par rapport au sens longitudinal du transducteur de flexion.

9. Soupape selon l'une des revendications 1 à 8, **caractérisée en ce que** l'au moins un corps piézoélectrique (4) est réalisé monobloc, et en particulier d'un seul tenant.

10. Soupape selon l'une des revendications 1 à 9, **caractérisée en ce que** le corps piézoélectrique (4) est disposé sur un substrat (17) piézoélectriquement inactif, de manière appropriée élastique à la manière d'un ressort.

11. Soupape selon la revendication 10, **caractérisée en ce que** le substrat piézoélectriquement inactif (17) a des propriétés de conduction électrique et forme directement une électrode unitaire (23) de l'unité d'électrodes (14).

12. Soupape selon l'une des revendications 1 à 11, **caractérisée en ce que** chaque paire d'électrodes partielles (18) est mise en contact avec un conducteur de raccordement électrique propre servant au transport de charge électrique (26a, 26b, 26c), dans le parcours duquel est insérée la résistance de limitation de courant (25a, 25b, 25c) affectée montée en série.
